# EUROPÄISCHE PATENTANMELDUNG

(11) **EP 1 732 228 A1**
(43) Veröffentlichungstag der Anmeldung: **13.12.2006**
(21) Anmeldenummer: 06011559.9
(22) Anmeldetag: 03.06.2006
(51) Int. Cl.: H03K 23/54, H03K 21/38

(54) **Frequenzteilerschaltung mit einem rückgekoppelten Schieberegister**

(30) Priorität: 10.06.2005 DE 102005028119
(71) Anmelder: ATMEL Germany GmbH, 74072 Heilbronn (DE)
(72) Erfinder: Schabel, Stefan, 89428 Syrgenstein (DE); Schulz, Holger, 89197 Weidenstetten (DE)

(57) **Zusammenfassung**

Vorgestellt wird eine Frequenzteilerschaltung (10) mit einer Kette von Flip-Flops, die durch eine Rückführung (12) zu einem das rückgekoppelten Schieberegister verbunden sind, und mit einer Startschaltung (20), die beim Einschalten der Frequenzteilerschaltung (10) einen deimierten Anfangszustand des Schieberegisters erzeugt. die Frequenzteilerschaltung (10) zeichnet sich dadurch aus, dass die Startschaltung (20) die Rückführung (12) nach einem Einschalten der Frequenzteilerschaltung (10) für eine vorbestimmte Zeitdauer blockiert.

## Beschreibung

Die Erfindung betrifft eine Frequenzteilerschaltung mit einer Kette von Flip-Flops, die durch eine Rückführung zu einem rückgekoppelten Schieberegister verbunden sind, und mit einer Startschaltung, die beim Einschalten der Frequenzteilerschaltung einen definierten Anfangszustand des Schieberegisters erzeugt.

Eine solche Frequenzteilerschaltung ist aus der US 6 459 310 B1 bekannt, die zur Realisierung der Flip-Flops Standard CMOS-Elemente vorschlägt und die Verwendbarkeit solcher CMOS-Elemente als besonders vorteilhaft herausstellt. Bei der bekannten Schaltung wird ein definierter initialer Zustand bei einem Einschalten (Power up) durch ein Reset-Signal erzeugt, das synchron jedem der Flip-Flops zugeführt wird. Daher benötigt die bekannte Schaltung neben einer Startschaltung, die das Reset-Signal bei einem Power Up bereitstellt, ein Leitungslayout mit einer Vielzahl von Reset-Leitungen. Diese Leitungen, die zusätzlich zu Taktsignalleitungen und Datensignalleitungen des Schieberegisters vorzusehen sind, vergrößern den Flächenbedarf der Schaltung.

Vor diesem Hintergrund besteht die Aufgabe der Erfindung in der Angabe einer Frequenzteilerschaltung mit einem reduzierten Flächenbedarf.

Diese Aufgabe wird bei einer Frequenzteilerschaltung der eingangs genannten Art dadurch gelöst, dass die Startschaltung die Rückführung nach einem Einschalten der Frequenzteilerschaltung für eine vorbestimmte Zeitdauer blockiert.

Eine unerwünschte Signalform wird daher wegen der blockierten (d.h. unterbrochenen) Rückführung nicht wieder in das Schieberegister eingespeist. Die unterbrochene Rückführung erlaubt die Einstellung eines definierten Resets des Schieberegisters bei einem Power Up mit einem verringerten Flächenbedarf. Beispielsweise werden bei unterbrochener Rückführung keine unerwünschten Zustände einzelner Flip-Flops in das erste Flip-Flop zurückgeführt und dieses kann stattdessen mit definierten Zuständen, beispielsweise logischen Nullen gespeist werden. Die definierten Zustände werden sequenziell getaktet durch das Schieberegister geschoben, bis sämtliche Flip-Flops mit den definierten Zuständen gefüllt sind, was einem definierten initialen Zustand des Schieberegisters entspricht. Für den Reset werden also gewissermaßen die Datenleitungen des Schieberegisters genutzt, so dass separate Reset-Leitungen nicht erforderlich sind. Daraus resultiert als weiterer entscheidender Vorteil, dass die einzelnen Flip-Flops keine separaten Resetfunktionen für einen synchronen Reset aller Flip-Flops aufweisen müssen, da sie gewissermaßen über ihren ohnehin vorhandenen Dateneingang sequenziell in einen definierten Zustand gesteuert werden. Daher können einfachere Flip-Flops verwendet werden, was zu einem weiter verringerten Flächenbedarf der Frequenzteilerschaltung führt.

Mit Blick auf Ausgestaltungen der Frequenzteilerschaltung ist bevorzugt, dass die vorbestimmte Zeitdauer größer oder gleich einer Anzahl von Perioden eines Taktsignals ist, das jedem Flip-Flop des Schieberegisters synchron zugeführt wird.

Auf diese Weise wird sichergestellt, dass sämtliche Flip-Flops in einem definierten Zustand sind, bevor die Rückführung geschlossen wird. Eine unerwünschte Rückführung unerwünschter Zustände und damit einhergehende unerwünschte Signalformen werden dadurch wirksam vermieden.

Bevorzugt ist auch, dass die Startschaltung ein Paar komplementärer MOS-Transistoren mit miteinander verbundenen Steueranschlüssen sowie ein RC-Glied aufweist, Leitfähigkeitsstrecken der MOS-Transistoren über einen Ohm'schen Widerstand des RC-Gliedes verbunden sind und in Reihe zwischen einem Versorgungspotenzial und einem Bezugspotenzial liegen, und eine Kapazität des RC-Gliedes parallel zu einer Leitfähigkeitsstrecke eines des MOS-Transistoren liegt.

Diese Ausgestaltung stellt eine schaltungstechnisch einfach zu realisierende Konkretisierung einer Startschaltung mit den gewünschten Eigenschaften dar. Grundsätzlich können rückgekoppelte Schieberegister, die als Frequenzteiler eingesetzt werden, unerwünschte Signalformen, zum Beispiel störende steigende und fallende Flanke innerhalb der sich wiederholenden Perioden zeigen. Die Startschaltung mit den genannten Merkmalen verhindert diesen unerwünschten Effekt. So werden zum Beispiel nach einem Triggerereignis wie einem Power up Signal (mindestens) so viele Nullen in das Schieberegister eingeschrieben, bis alle Zellen des Schieberegisters garantiert auf Null liegen. Dann ist ein definierter Start des synchronen Frequenzteilers gewährleistet, durch den unerwünschte Signalformen sicher vermieden werden.

Bevorzugt ist auch, dass die Flip-Flops emittergekoppelte Bipolartransistoren als Schaltelemente aufweisen (ECL-Technik, ECL = emitter coupled logic).

Üblicherweise, und so auch bei der US 6 459 310, sind die einzelnen Flip-Flops in CMOS-Technik realisiert. Die CMOS-Technik zeichnet sich bekanntlich durch einen im Vergleich zur Bipolartechnik im Allgemeinen geringeren Strombedarf aus, der sich aus der Spannungssteuerung der beteiligten MOS-Transistoren ergibt. Im statischen Betrieb ist der Stromverbrauch von CMOS-Schaltungen daher vergleichsweise gering. Bipolartransistoren erfordern dagegen auch im statischen Betrieb gewisse Steuerströme. Bei realen Schaltvorgängen, also im dynamischen Betrieb, verbrauchen jedoch auch CMOS-Schaltungen Strom, da die Gate-Kapazitäten der MOS-Transistoren bei der Steuerung umgeladen werden. Dieser Stromverbrauch steigt mit der Zahl erforderlicher Umladevorgänge und wächst daher mit der Frequenz an. Ferner ist der Stromverbrauch von der Strukturbreite der CMOS-Bauelemente abhängig und sinkt mit abnehmender Strukturbreite. Die Frequenzabhängigkeit des Stromverbrauchs von CMOS-Schaltungen ist insbesondere bei höheren Frequenzen eines zu teilenden Taktsignals nachteilig. Unter höheren Frequenzen werden in diesem Zusammenhang Frequenzen größer als etwa 200 MHz, insbesondere größer als etwa 400 MHz verstanden, wie sie zum Beispiel bei spannungsgesteuerten Oszillatoren in GPS-Empfängern oder bei einer Erzeugung von Standardfrequenzen für einen GPS-Empfänger aus einer Referenzfrequenz verwendet werden.

Dass die Verwendung von Bipolartransistoren in diesem Zusammenhang Vorteile bietet, ist zunächst überraschend, da Bipolartransistoren stromgesteuerte Bauelemente darstellen, die bereits im statischen Betrieb einen gewissen Strombedarf aufweisen. Bei niedrigen Frequenzen ist dieser Strombedarf auf jeden Fall höher als der Strombedarf von CMOS-Schaltungen. ECL-Schaltungen besitzen die kleinsten Gatterlaufzeiten aller Logikfamilien und weisen nur geringe Kollektor-Basis-Sperrschichtkapazitäten auf. Sie werden mit vergleichsweise kleinen Signalamplituden von einigen hundert mV umgeschaltet. Dadurch werden die unvermeidlichen Schaltkapazitäten schnell umgeladen. Auch der niedrige Ausgangswiderstand der Emitterfolger begünstigt kurze Schaltzeiten. Allerdings ist die hohe Schaltgeschwindigkeit der ECL-Schaltungen in der Regel mit einer hohen Verlustleistung verbunden.

Ein großer Vorteil der emittergekoppelten Bipolartransistoren liegt jedoch darin, dass ihr Strombedarf näherungsweise frequenzunabhängig ist. Es hat sich gezeigt, dass bei einer gewissen Übergangsfrequenz die jedenfalls kleiner als 400 MHz ist, der frequenzabhängige Strombedarf von CMOS-Latches den näherungsweise von der Frequenz des Taktsignals unabhängigen Strombedarf emittergekoppelter Bipolartransistoren übersteigt. Die Frequenz von 400 MHz ist jedoch nicht als scharfe, allgemeingültige Angabe zu verstehen, die für alle CMOS-Technologien und Bipolar-Technologien gültig ist, da der Stromverbrauch der CMOS-Schaltungen auch von deren Strukturbreite abhängt und mit abnehmender Strukturbreite sinkt. Mit abnehmender Strukturbreite kann die Grenzfrequenz, ab der Bipolartransistoren günstigere Eigenschaften aufweisen, daher auch höher liegen. Die Angabe von 400 MHz ist jedoch insbesondere bei CMOS-Strukturbreiten von 0,35 Mikrometern gültig.

Ferner ist bevorzugt, dass die Rückführung einen ersten Rückführzweig, einen zweiten Rückführzweig sowie ein Und-Glied aufweist, wobei das Und-Glied den ersten Rückführzweig und den zweiten Rückführzweig mit einem Daten-Eingang eines ersten Flip-Flops des Schieberegisters verbindet und wobei der erste Rückführzweig von einem vorletzten Flip-Flop und der zweite Rückführzweig von einem letzten Flip-Flop des Schieberegisters gespeist wird.

Diese Ausgestaltung mit einem synchron getakteten Schieberegister zeichnet sich durch eine vorteilhaft geringe Empfindlichkeit gegenüber Produktionstoleranzen und Temperatureinflüssen aus. Außerdem ergibt sich ein Tastverhältnis des geteilten Signals, das sich mit zunehmendem Frequenzunterschied zwischen Taktsignal und geteiltem Signal, also mit zunehmendem Teilerverhältnis, dem Idealwert von 50 % annähert. Bei einem Teilerverhältnis von 13 (Frequenz des Taktsignals entspricht der 13-fachen Frequenz des geteilten Signals) ergibt sich bereits ein Tastverhältnis von 46 %.

Bevorzugt ist auch, dass Ausgänge des letzten und des vorletzten Flip-Flops des Schieberegisters durch ein Oder-Glied verknüpft werden und dass ein Ausgang des Oder-Gliedes einen Ausgang der Frequenzteilerschaltung bildet.

Durch diese Ausgestaltung wird ein Tastverhältnis von 50 % im Ausgangssignal der Frequenzteilerschaltung erzielt.

Eine bevorzugte Verwendung ergibt sich nach diesen Ausführungen insbesondere bei einer Taktsignalfrequenz (Grenzfrequenz), die größer als 200 MHz, insbesondere größer als 400 MHz ist.

Die vorgestellten Frequenzteilerschaltungen können zum Beispiel zur Erzeugung einer GPS-Standardfrequenz aus einer internen Referenzfrequenz eines Kommunikationsgerätes verwendet werden.

Durch diese Ausgestaltung kann ein eigener Referenzfrequenzgeber (z.B. ein Schwingquarz) für die GPS-Standardfrequenz eingespart werden, wenn ein GPS-Empfänger zum Beispiel in ein mobiles Kommunikationsgerät, z.B. ein Mobiltelefon, integriert ist, das bereits einen internen Referenzfrequenzgeber aufweist.

Bevorzugt ist auch, dass die GPS-Standardfrequenz durch eine Kette von Frequenz-Multiplizierem und Frequenzteilern und eine Phasenregelschleife erzeugt wird.

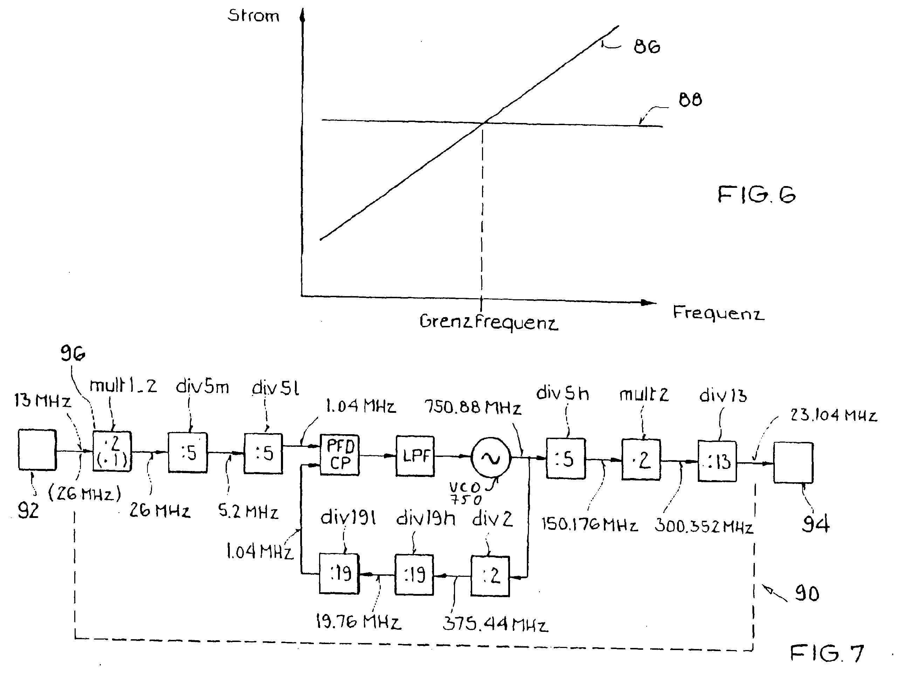

Wie weiter unten unter Bezug auf die Fig. 7 erläutert wird, lassen sich auf diese Weise auch ungeradzahlige Verhältnisse zwischen einer internen Referenzfrequenz eines mobilen Kommunikationsgerätes und der gewünschten GPS-Frequenz sowohl stabil als auch flächen- und stromsparend erzeugen.

Bevorzugt ist auch, dass Frequenzteiler der Kette, die eine Frequenz teilen, die größer als eine Grenzfrequenz ist, in bipolarer Technik realisiert sind, während Frequenzteiler der Kette, die eine Frequenz teilen, die kleiner als die Grenzfrequenz ist, in CMOS-Technik realisiert sind.

Dadurch wird in der Summe der Strombedarf der Kette minimiert. Dies ist insbesondere für mobile Anwendungen vorteilhaft, bei denen der Stromverbrauch wegen begrenzter Akku-Kapazitäten eine kritische Größe darstellt.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: ein erstes Ausführungsbeispiel einer erfindungsgemäßen Frequenzteilerschaltung;
- Fig. 2: zeitlich korrelierte Verläufe verschiedener Signale, die in der Frequenzteilerschaltung der Fig. 1 auftreten;
- Fig. 3: eine Ausgestaltung einer Startschaltung;
- Fig. 4: ein einzelnes, in bipolarer ECL-Technik aufgebautes Latch;
- Fig. 5: ein zwei Latches der Fig. 4 aufweisendes Master-Slave Flip Flop;
- Fig.6: qualitativ eine Stromaufnahme eines erfindungsgemäßen Frequenzteilers über der Frequenz im Vergleich zu einem bekannten, mit Standard-CMOS-Zellen arbeitenden Frequenzteiler; und
- Fig. 7: eine Frequenzkonvertierungsschaltung, die eine typische interne Referenzfrequenz eines Mobiltelefons in eine gebräuchliche Standardfrequenz für eine GPS-Anwendung konvertiert.

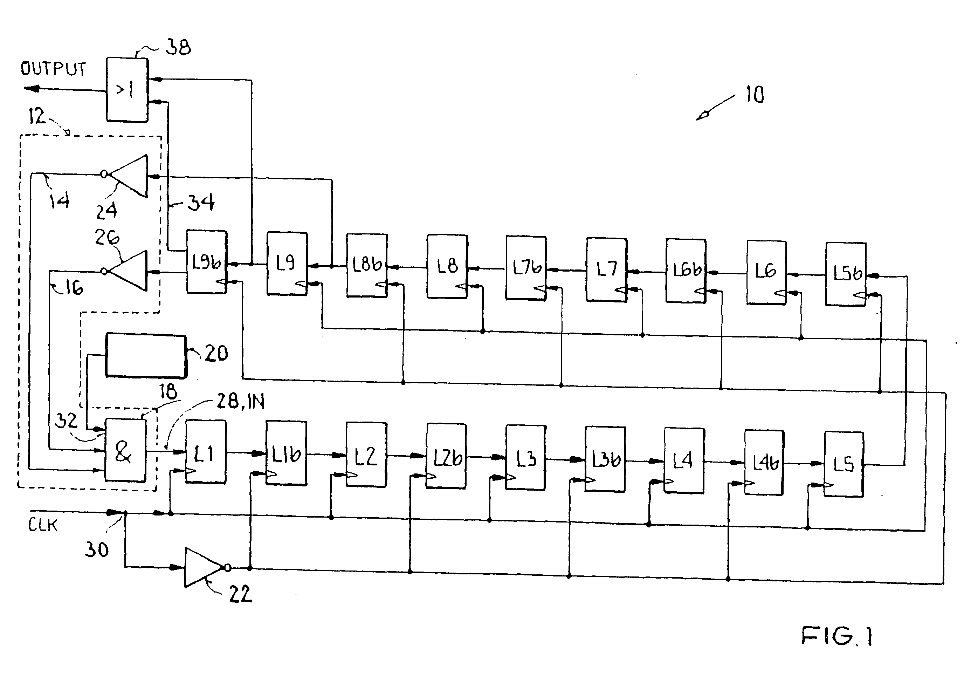

Im Einzelnen zeigt Fig. 1 einen prinzipiellen Aufbau einer synchronen (1:17)-Frequenzteilerschaltung 10 mit Merkmalen der Erfindung. Die Frequenzteilerschaltung 10 besteht aus einem rückgekoppelten Schieberegister mit i_max = 9 MSD Flip-Flops aus je zwei Latches Li, Lib mit i = 1, 2, .... , i_max = 9, die mit einer Rückführung 12 aus einem ersten Rückführzweig 14, einem zweiten Rückführzweig 16 und einem Und-Glied 18, sowie mit einer Startschaltung 20 zu einem rückgekoppelten Schieberegister verbunden sind. Je zwei Latches Li, Lib mit gleichem Index i bilden zusammen mit dem Inverter 22 ein MSD-Flip-Flop. Eine bevorzugte Ausgestaltung eines solchen MSD-Flip-Flops, dessen einzelne Latches in bipolarer Schaltungstechnik realisiert sind, wird weiter unten erläutert.

Ausgänge des sechzehnten Latches (L8b) und des achtzehnten Latches (L9b) werden invertiert auf den Eingang des ersten Latches (L1) über die Rückführzweige 14 und 16 zurückgekoppelt. Dazu weist jeder der beiden Rückführzweige 14, 16 einen Inverter 24, 26 auf.

Jeder Signalpfeil in der Fig. 1 repräsentiert Leitungen für je ein differenzielles Signal. Der Signalpfeil 28 repräsentiert zum Beispiel Leitungen für ein differenzielles Eingangssignal aus Werten Wd, Wdn, wie es weiter unten noch näher erläutert wird.

Entsprechend repräsentieren die weiteren Signalpfeile Leitungen, die dieses differenzielle Eingangssignal mit einer von der Zahl der vorhergehenden Latches Lj, Ljb abhängigen Verzögerung an ein folgendes Latch Lj+1, Lj+1b übergeben.

Ein differenzielles Taktsignal CLK wird an einem Eingang 30 des Frequenzteilers 10 eingespeist. Der erste Rückführzweig 14 ist vor dem vorletzten Latch Li_max-1 (in der Fig. 1: zwischen L8b und L9) an den Signalpfad angeschlossen und greift dort ein Signal ab. Dieses Signal, das dem Eingangssignal des letzten MSD-Flip-Flops entspricht, wird in invertierter Form an das Und-Glied 18 übergeben.

Ferner übergibt der zweite Rückführzweig 16 auf analoge Weise das invertierte Ausgangssignal des letzten MSD-Flip Flops aus den Latches L9, L9b an das Und-Glied 18. Das Und-Glied 18 weist ferner einen Eingang 32 für die Startschaltung 20 auf, die weiter unten noch näher erläutert wird. Für ein Verständnis der Funktion des Frequenzteilers 10 reicht es zunächst aus, dass die Startschaltung 20 in Verbindung mit dem Und-Glied 18 die Rückführung 12 in vorbestimmter Weise blockieren kann, um einen definierten initialen Zustand des Schieberegisters zu erzeugen.

Das Und-Glied 18 liefert nur dann eine logische Eins als Eingangssignal IN an das erste Latch L1, wenn alle Eingänge des Und-Gliedes 18 auf Eins stehen. Solange die Startschaltung 20 eine logische Null liefert, steht am Eingang des ersten Latches L1 eine logische Null. Die logische Null wird dann im Takt des Taktsignals durch sämtliche Latches Li, Lib durchgeschoben, so dass das Schieberegister für einen Initialzustand sequenziell komplett mit Nullen gefüllt wird.

Bei der ersten steigenden Flanke des Taktsignals geht L1 auf Null, bei der ersten fallenden Flanke geht L1b auf Null, bei der zweiten steigenden Flanke geht L2 auf Null, bei der zweiten fallenden Flanke geht L2b auf Null, und so weiter, bis bei der i_max = neunten fallenden Flanke L9b auf Null geht und das Schieberegister komplett mit Nullen gefüllt ist.

Wegen den Invertierungen 24, 26 in den Rückführzweigen 14, 16 stehen dann am Und-Glied 18 zwei logische Eins-Werte und das Signal der Startschaltung 20 an. Geht die Startschaltung 20 dann auch auf Eins, schaltet das Und-Glied 18 sein Ausgangssignal IN von einer logischen Null auf eine logische Eins um. Diese logische Eins 1 wird ebenfalls sukzessive verzögert durch das Schieberegister geschoben, bis die Eins am Ausgang von L8b auftaucht. Diese Eins wird dann in dem ersten Rückführzweig 14 invertiert, was letztlich das Und-Glied 18 umschaltet, so dass dieses wieder logische Nullen in das Schieberegister einspeist. Nach einer weiteren fallenden Flanke im Taktsignal liefert auch der zweite Rückführzweig 16 eine invertierte Eins, also eine Null, an das Und-Glied 18.

Die vom Und-Glied 18 ausgegebenen Nullen werden sukzessive durch das Schieberegister geschoben, bis sowohl der erste Rückführzweig 14 als auch der zweite Rückführzweig 16 wieder eine Eins an das Und-Glied 18 liefern.

Bei weiterer Fortführung werden am Eingang jedes Latches Li, Lib, für jeweils 17 volle Perioden des Taktsignals abwechselnd neun Nullen und acht Einsen erzeugt. Dabei werden die Latches L1 bis L9 mit der positiven Flanke des Eingangssignals IN getriggert, während die Latches L1b bis L9b durch den Inverter 22 mit der negativen Flanke des Eingangssignals IN getriggert werden. Am Eingang des L1 tauchen neun Nullen in Folge auf. Danach liegen an diesem Eingang für acht aufeinander folgende Takte Einsen an. Diese Periode oder Signalform (00000000011111111) stellt sich immer ein, wenn das Schieberegister mit der Startschaltung 20 in den definierten initialen Zustand versetzt worden ist. Die Frequenzteilerschaltung 10 teilt die Frequenz des Taktsignals CLK durch einen Faktor 17 und erzeugt dabei ein Ausgangssignal mit einem Tastverhältnis von 8/17 = 47,6 %, das am Ausgang des Latches L9b abgegriffen werden kann. Das dadurch definierte Signal besitzt also die 17-fache Periodendauer und damit 1/17 der Frequenz des Taktsignals CLK. Durch die Festlegung der Zahl 2*i_max der Latches Li, Lib kann damit jedes ungeradzahlige Teilerverhältnis realisiert werden.

Soweit wie bisher beschrieben, weist das Signal mit der geteilten Frequenz noch ein vom Idealwert von 50 % abweichendes Tastverhältnis auf, da sich im Fall des beschriebenen 1/17-Teilers für den Anteil 8/17 einer Periode ein hoher Pegel (Pegel =1) und für 9/17 einer Periode ein niedriger Pegel (Pegel = 0) ergibt.

Die Abweichung ist dabei proportional zu einem Faktor 1/n, wenn n die um 1 verringerte Zahl der Latches Li, Lib ist, also n = 2 * i_max - 1.

Am Ausgang des optional verwendbaren Oder-Gliedes 38 kann dagegen ein Ausgangssignal OUTPUT mit der geteilten Frequenz mit einem Tastverhältnis von 50 % abgegriffen werden.

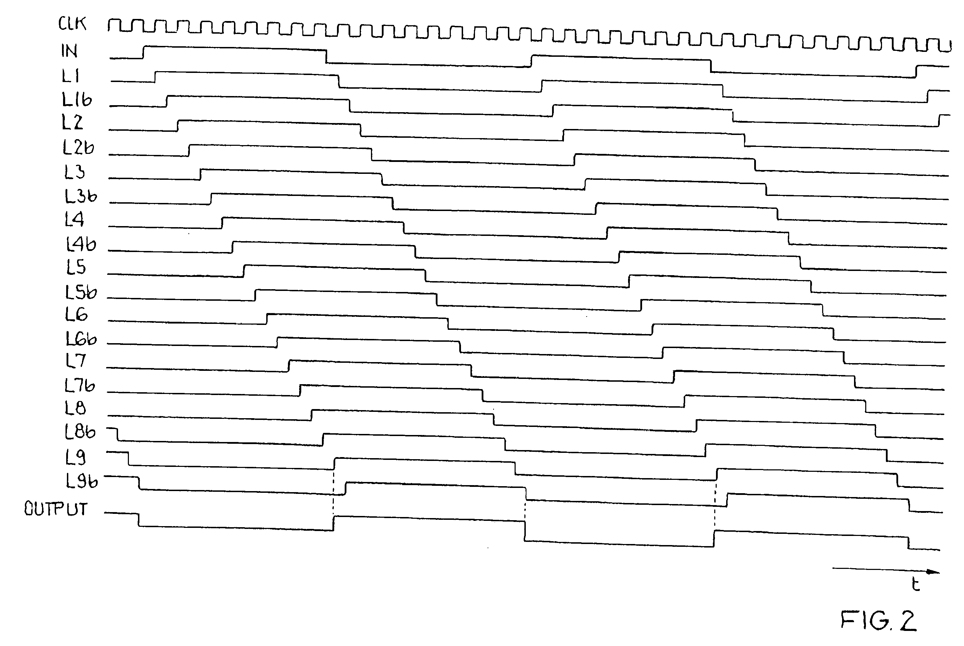

Fig. 2 zeigt zeitlich korrelierte Verläufe der erwähnten Signale CLK, IN, OUTPUT sowie der Ausgangssignale der Latches Li, Lib nach einem definierten Start des Schieberegisters nach einem Power Up.

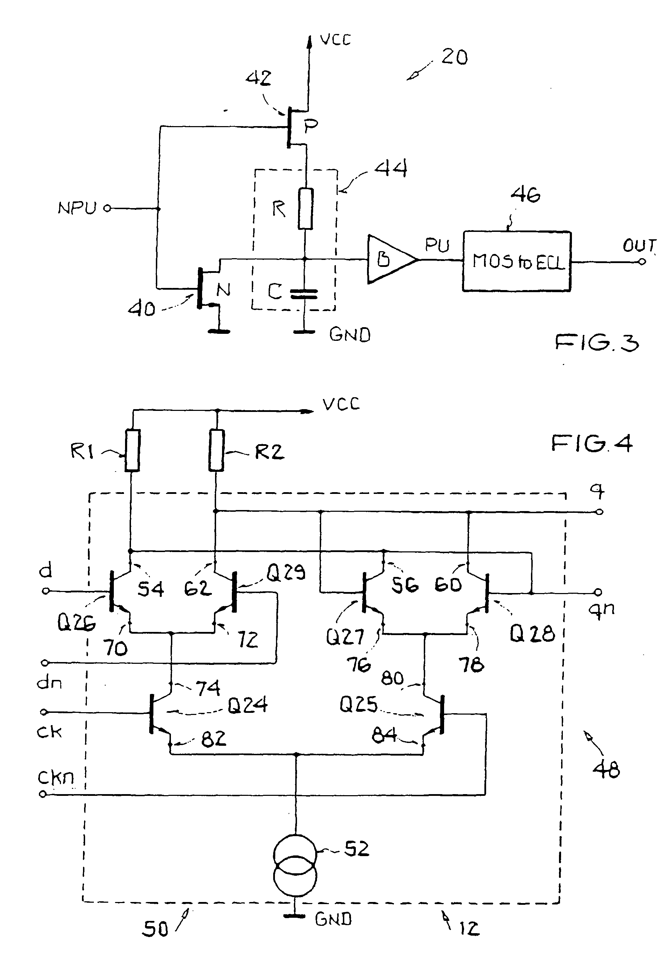

Fig. 3 zeigt eine Ausgestaltung einer Startschaltung 20, die ein Paar komplementärer MOS-Transistoren 40, 42 mit miteinander verbundenen Steueranschlüssen sowie ein RC-Glied 44 aufweist. Dabei sind Leitfähigkeitsstrecken der MOS-Transistoren 40, 42 über einen Ohm'schen Widerstand R des RC-Gliedes 44 verbunden und liegen in Reihe zwischen einem Versorgungspotenzial VCC und einem Bezugspotenzial gnd. Eine Kapazität C des RC-Gliedes 44 liegt parallel zu einer Leitfähigkeitsstrecke eines des MOS-Transistoren 40, 42. Die Startschaltung 20 wird dadurch aktiviert, dass ein Triggersignal an einem Eingang NPU (NPU = Not Power UP) von Eins (Power Down) auf Null (Power up) geschaltet wird. Der NMOS Transistor 40 wird in diesem Moment gesperrt und der PMOS Transistor 42 wird leitend gesteuert. Somit wird die Kapazität C über den Widerstand R aufgeladen. Die Zeitkonstante R*C dieses RC Gliedes 44 bestimmt die verzögerte Weitergabe des Triggersignals an einen Ausgang OUT der Startschaltung 20. Am Ausgang eines optionalen CMOS Buffers B kann das verzögerte Power up Signal PU abgegriffen werden.

Für den Einsatz als Startschaltung 20 in einem bipolaren, synchronen Frequenzteiler 10 mit in ECL-Technik realisierten Latches muss das CMOS-Signal PU in ein ECL-Signal gewandelt werden, was durch den Block 46 (MOS to ECL) erfolgt. Das Ausgangsignal OUT der Startschaltung 20 wird nun zusammen mit den rückgekoppelten Signalen in den Rückführzweigen 14, 16 des Schieberegisters auf das UND-Gatter 18 aus der Fig. 1 gegeben. Dies hat zur Folge, dass nach Aktivierung des Frequenzteilers 10 durch ein Triggersignal am Eingang NPU der Startschaltung 20 zunächst das Schieberegister mit Nullen gefüllt wird. Erst wenn das Ausgangssignal am Ausgang OUT der Startschaltung 20 von "Low" nach "High" wechselt, wird die Rückkopplung des Schieberegisters aktiv. Der Frequenzteiler 10 aus der Fig. 1 startet in einem definierten Zustand, wenn die Zeitkonstante der Startschaltung 20 groß genug ist (für den Teiler in Fig. 1: größer als 9 Takte des Taktsignals CLK), um das komplette Schieberegister mit Nullen zu füllen.

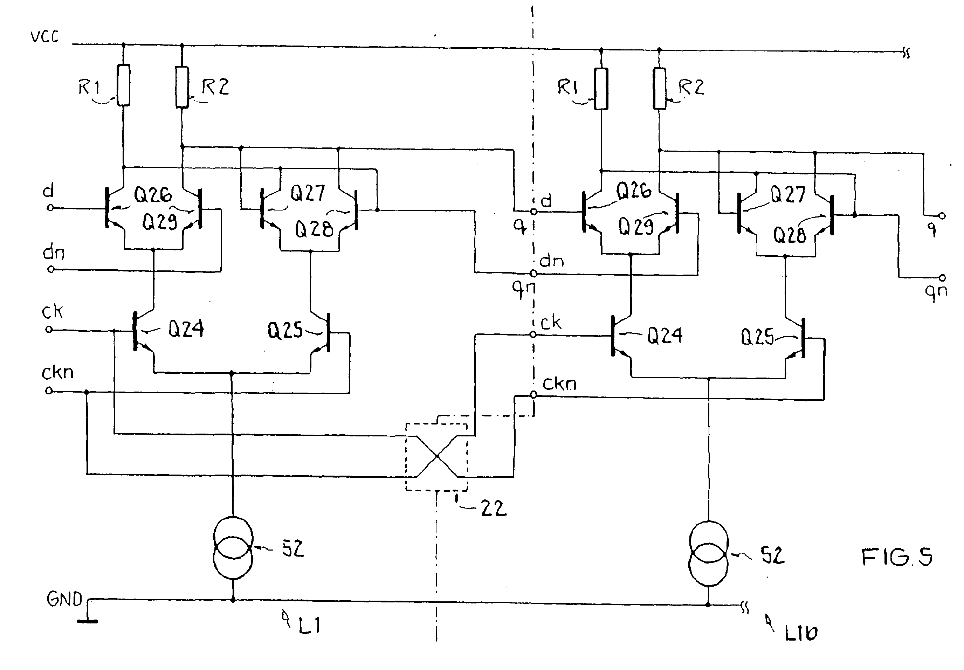

Im Folgenden wird unter bezug auf die Figuren 4 und 5 eine bevorzugte Ausgestaltung eines Latches, beziehungsweise eines aus zwei Latches aufgebauten Flip Flops erläutert. Im Einzelnen zeigt die Fig. 4 ein Latch 48 in Bipolartechnik. Das Latch 48 weist einen kaskadierten Differenzverstärker 50 aus einer Konstantstromquelle 52, einer ersten Differenzstufe aus Transistoren Q24, Q25, einer zweiten Differenzstufe aus Transistoren Q26, Q29, einer dritten Differenzstufe aus Transistoren Q27 und Q28, sowie einen ersten Widerstand R1 und einen zweiten Widerstand R2 auf und liegt zwischen einem Versorgungsspannungsanschluss VCC und einem Bezugspotenzialanschluss gnd.

Erste Stromanschlüsse 54, 56 der Transistoren Q26 und Q27 sind miteinander verbunden und bilden Ausgänge q, qn des Latches 48. Ferner sind sie an einen Steueranschluss 58 des Transistors Q28 und über den ersten Widerstand R1 an VCC angeschlossen.

Erste Stromanschlüsse 60, 62 der Transistoren Q28 und Q29 sind miteinander und einem Steueranschluss 68 des Transistors Q27 verbunden sowie über den zweiten Widerstand R2 an VCC angeschlossen.

Zweite Stromanschlüsse 70, 72 der Transistoren Q26, Q29 sind miteinander und einem ersten Stromanschluss 74 des Transistors Q24 verbunden. Analog dazu sind zweite Stromanschlüsse 76, 78 der Transistoren Q27, Q28 miteinander und einem ersten Stromanschluss 80 des Transistors Q25 verbunden. Zweite Stromanschlüsse 82, 84 der Transistoren Q24, Q25 sind gemeinsam an die Konstantstromquelle 52 angeschlossen, die im Übrigen an gnd liegt.

In der Darstellung der Fig. 4 sind die ersten Stromanschlüsse 54, 62, 56, 60, 74, 80 jeweils Kollektoranschlüsse und die zweiten Stromanschlüsse 70, 72, 76, 78, 82, 84 jeweils Emitteranschlüsse von npn Bipolar-Transistoren Q24, ... , Q29. Es versteht sich aber, dass Latches 48 auch mit pnp-Transistoren realisiert werden können, wenn man sämtliche Polaritäten vertauscht.

Insgesamt stellt der Gegenstand der Fig. 4 ein Latch 48 in ecl-Technik dar (ec1 = emitter coupled logic). Bei der ecl-Technik wird mit differenziellen Signalen gearbeitet, deren Pegelhöhen in einer Größenordnung von wenigen hundert mV differieren. Im Folgenden wird ein hoher ecl-Pegel auch als logische Eins und ein niedriger ecl-Pegel als logische Null betrachtet.

Über Taktsignalanschlüsse ck, ckn wird die erste Differenzstufe mit einem binären Taktsignal differenziell ausgesteuert. Eingangssignalanschlüsse d, dn dienen zur differenziellen Aussteuerung der zweiten Differenzstufe.

In Abhängigkeit von den Werten Wck, Wckn (CLK in der single ended Darstellung der Fig. 1) des Taktsignals an den Anschlüssen ck ,ckn und Werten eines Eingangssignals Wd, Wdn (Signal IN in der Fig. 1) ergeben sich Werte Wq, Wqn an den Ausgängen q, qn entprechend der folgenden Tabelle:

| | |
|---|---|
| Wd, Wdn; Wck, Wckn | q, qn |
| 1, 0; 1, 0 | 1,0 |
| 1, 0; 0, 1 | vorherige Werte werden erhalten bis Wck = 1 wird |
| 0,1;1,0 | 0,1 |
| 0, 1; 0, 1 | vorherige Werte werden erhalten bis Wck = 1 wird |

Die Werte der ersten Zeile der Tabelle ergeben sich aus folgenden Zusammenhängen: Wd = 1 steuert den Transistor Q26 leitend, während Wdn = 0 den Transistor Q29 sperrt. Wck = 1 steuert den Transistor Q24 leitend, während Wckn = 0 den Transistor Q25 sperrt. Als Folge ergibt sich ein Strom von VCC über R1, Q26 und Q24 zur Konstantstromquelle 52, der einen Spannungsabfall über R1 erzeugt. Der Spannungsabfall über R1 senkt das Potenzial am ersten Stromanschluss 54 von Q26 und damit am Ausgang qn auf VCC -R1*I, was per Definition hier einer logischen Null entsprechen soll. Über R2 fließt dagegen kein Strom, so dass über R2 auch keine Spannung abfällt. Dann stellt sich am Ausgang q eine logische Eins ein. Die Werte der Zeile 3 der Tabelle ergeben sich in analoger Weise.

Die Werte der zweiten Zeile der Tabelle ergeben aus Folgendem: Wck = 0 sperrt Q24 und es fließt kein Strom über die erste Differenzstufe Q26, Q29. Wenn vorher q = 0 war, wird Q28 leitend, so dass q = 0 bleibt. Wenn vorher q = 1 war, wird Q27 leitend und q bleibt ebenfalls auf dem Wert 1. Analog ergibt sich Zeile 4 der Tabelle.

Fig. 5 zeigt ein aus zwei Latches L1, L1b und einem Inverter 22 aufgebautes Master-Slave-Flip-Flop. Wie man bei einem Vergleich mit der Fig. 4 erkennt, entspricht sowohl der Master L1, als auch der Slave L1b jeweils für sich betrachtet einem Latch 48, wie es in der Fig. 4 dargestellt ist. Ausgänge q, qn des Masters L1 sind mit Eingängen d, dn des Slaves L1b verbunden. Der Slave L1b wird mit einem Taktsignal gesteuert, das dem invertierten Taktsignal CLK für den Master L1 entspricht. Ein entsprechender Inverter 22 kann durch eine Leitungskreuzung realisiert sein. Dies gilt im übrigen auch für die Inverter 24 und 26 aus der Fig. 1.

Im Folgenden wird kurz beschrieben, wie ein Eingangssignal Wd, Wdn = 0, 1 von Eingängen d, dn des Masters L1 zu den Ausgängen q, qn des Slaves L1b fortschreitet.

Ausgehend von einem undefinierten Zustand ohne Eingangssignal sei das Eingangsignal Wd, Wdn = 0, 1 und das Taktsignal Wck, Wckn = 1, 0. Dies entspricht der Zeile 3 der oben angegebenen Tabelle. Am Ausgang des Masters L1 und damit am Eingang des Slaves L1b stellen sich also Werte 0, 1 ein. Da der Slave L1b das invertierte Taktsignal 0, 1 empfängt, ergibt sich sein Zustand dann entsprechend der Tabelle, Zeile 4 als zunächst undefinierter, von der Vorgeschichte abhängiger Wert. Mit anderen Worten: Der Slave L1 ist blockiert oder verriegelt (d.h.: Der alte Wert bleibt erhalten).

Bei gleichem Eingangssignal 0, 1 gehe das Taktsignal für L1 dann auf 0, 1. Dann ist der Master entsprechend der Zeile 4 der Tabelle verriegelt und liefert an seinem Ausgang entsprechend seiner Vorgeschichte das Signal 0, 1. Der Slave L1b wird durch das invertierte Taktsignal 0, 1 entriegelt, liest das Eingangssignal 0, 1 ein und stellt es an seinem Ausgang bereit. Dabei ist der Master L1 verriegelt.

In der Summe wird das Eingangssignal 0, 1 bei steigender Flanke des Taktsignals in den Master L1 eingelesen und erscheint verzögert bei der nächsten fallenden Flanke im Taktsignal am Ausgang des Slaves L1b. Tritt bei der zweiten Taktperiode bei hohem Pegel 1 des Taktsignals (Taktsignal = 1, 0) am Eingang von L1 ein Wechsel des Eingangssignals von 0, 1 auf 1, 0 auf, wird dieses Eingangssignal bei verriegeltem Slave L1b in den Master L1 eingelesen und bei der nächsten fallenden Flanke bei entriegeltem Slave L1b und verriegeltem Master L1 am Ausgang von L1b bereitgestellt.

Mit anderen Worten: Das Paar aus Flip-Flops L1 und L1b bildet zusammen mit dem Inverter 22 ein Master-Slave Flip-Flop. L1 und L1b werden durch das Taktsignal Wck, Wckn komplementär zueinander verriegelt. In einem Zeitraum, in dem Wck gleich 1 ist, wird eine Information in den Master L1 eingelesen. Der Ausgangszustand von L1b bleibt dabei unverändert, da L1b als Slave in diesem Zeitraum blockiert ist.

Wenn Wck auf 0 geht, wird der Master L1 verriegelt und damit der Zustand eingefroren, der unmittelbar vor der fallenden Flanke geherrscht hat. In diesem Fall ist dies der Zustand 0, 1 des Datensignals Wd, Wdn. Gleichzeitig wird der Slave L1b freigegeben und damit der Zustand des Masters L1, also der Zustand 1, an den Ausgang von L1b übertragen. Die Datenübertragung findet also bei der negativen Taktflanke statt.

Liegt am Eingang des Masters L1 eine Null an, wird diese bei Takt Wck = 1 in den Master L1 eingelesen. Bei Takt Wck = 0 erfolgt die Weitergabe der eingelesenen Null an den Ausgang des Slave L1b.

Fig. 6 veranschaulicht qualitativ die Vorteile dieser Ausgestaltung der einzelnen Flip-Flops in ECL-Technik gegenüber Standard-CMOS-Flip-Flops durch eine Auftragung des jeweiligen Strombedarfs über der Frequenz des Taktsignals. Der linear ansteigende Verlauf 86 gehört zu den CMOS-Flip-Flops, während der konstante Verlauf 88 den Strombedarf der ECL-Flip-Flops widerspiegelt. Wie man erkennt, ist der Strombedarf der ECL-Flip-Flops oberhalb einer Grenzfrequenz kleiner als der Strombedarf der Standard CMOS-Flip-Flops.

Im Folgenden wird unter Bezug auf die Figur 7 eine Verwendung von Ausgestaltungen der Erfindung vorgestellt, bei der sich sämtliche oben genannten Vorteile einstellen. Eine Frequenzkonvertierungsschaltung 90 liegt zwischen einem Block 92, der die Funktionen eines mobilen Kommunikationsgerätes repräsentiert, und einem Block 94, der eine GPS-Anwendung repräsentiert, die in das mobile Kommunikationsgerät integriert ist. Dabei wird im Folgenden davon ausgegangen, dass für die Funktionen des mobilen Kommunikationsgerätes bereits eine interne Referenzfrequenz von 13 MHz oder 26 MHz im Block 92 bereitgestellt wird. Bei der Verarbeitung von GPS-Signalen im Block 94 sind andere Frequenzen erforderlich. Gebräuchliche GPS-Standardfrequenzen sind z. B. 10,949297 MHz, 16,3676 MHz, 16,368 MHz, 21,73875 MHz, 23,104 MHz, 24,5535 MHz und 27,456 MHz. Prinzipiell kann jede dieser GPS-Standardfrequenzen über einen eigenen Schwingquarz bzw. quarzstabilen Oszillator (z.B. "TCXO" = temperature compensated crystal oscillator) bereitgestellt werden. Schwingquarze sind jedoch vergleichsweise teuer. Bei Geräten, die für andere Frequenzen (hier 13 MHz oder 26 MHz) bereits einen Schwingquarz aufweisen, kann eine GPS-Standardfrequenz strom- und flächensparend mit Hilfe der Frequenzkonvertierungsschaltung 90 aus der im Block 92 vorhandenen Referenzfrequenz erzeugt werden. Die in der Figur 7 dargestellte Frequenzkonvertierungsschaltung 90 erzeugt z. B. aus einer Frequenz von 13 MHz oder 26 MHz die GPS-Standardfrequenz von 23,104 MHz mithilfe von Multiplikationen mit und Divisionen durch natürliche Zahlen.

Die benötigten Teilungen hoher Frequenzen lassen sich mithilfe der erfindungsgemäßen Teilerschaltung schaltungstechnisch realisieren. Die benötigten natürlichen Zahlen lassen sich durch Erweitern des Quotienten aus vorhandener Referenzfrequenz (hier 13 MHz oder 26 MHz) und gewünschter GPS-Frequenz (hier 23,104 MHz) auf natürliche Zahlen im Zähler und Nenner und anschließende Zerlegung von Zähler und Nenner in Primfaktoren bestimmen. So ergibt sich zum Beispiel die gewünschte Frequenz von 23,104 MHz durch Multiplikation einer Frequenz von 26 MHz mit den Primfaktoren 2, 2, 19, 19 und Division durch die Primfaktoren 5, 5, 5, 13. Die Frequenzkonvertierungsschaltung 90 nach Figur 7 realisiert diese Teilungen und Multiplikationen unter zusätzlicher Verwendung einer frequenzstabilisierenden Phasenregelschleife aus einem auf 750 MHz ausgelegten, spannungsgesteuerten Oszillator VCO 750, einem (1:2)-Teiler div2, einem (1:19)-Teiler div19h, einem weiteren (1:19)-Teiler div19l, einem Phasen-Frequenz-Vergleicher PFD mit Ladungspumpe CP und einen Schleifenfilter LPF. Der Phasenregelschleife ist ein erster (1:5)-Teiler div5m und ein zweiter (1:5)-Teiler div51 vorgeschaltet, die die vorhandene Frequenz von 26 MHz sukzessive auf 5,2 MHz und 1,04 MHz herunterteilen. Für den Fall, dass der Block 92 statt 26 MHz eine interne Referenzfrequenz von 13 MHz bereitstellt, wird diese im Block mult1_2 mit dem Faktor 2 multipliziert, so dass am Eingang des ersten (1:5)-Teilers div5m auf jeden Fall 26 MHz anliegen. Zur Auswahl der Faktoren 2 oder 1 in Abhängigkeit von den im Block 92 vorhandenen internen Referenzfrequenzen in Höhe von 13 MHz oder 26 MHz weist der Block mult1_2 einen Eingang 96 auf. Die Auswahl der Multiplikationsfaktoren erfolgt z. B. bei der Applikation der Frequenzkonvertierungsschaltung 90 an ein vorhandenes Mobiltelefon. Die hinter dem zweiten (1:5)-Teiler div 51 abgreifbare Frequenz von 1,04 MHz dient als Referenzfrequenz der Phasenregelschleife, die die Frequenz des VCO 750 entsprechend der in der Schleife verwendeten Teiler div2, div19h und div19l auf das 722fache von 1,04 MHz, also auf 750,88 MHz, einregelt. Bei der Auswahl der Frequenz des VCO's 750 und der Referenzfrequenz der Phasenregelschleife ist Folgendes zu beachten: Einerseits steigt die Genauigkeit und Stabilität der Frequenzkonvertierung mit zunehmender Oszillatorfrequenz und zunehmendem Abstand zwischen der Oszillatorfrequenz und der Referenzfrequenz an. Andererseits steigt auch der Energieverlust im VCO mit steigender Frequenz, was insbesondere bei mobilen Anwendungen kritisch ist. Eine Erhöhung des Abstandes zwischen der Oszillatorfrequenz und der Referenzfrequenz durch weiteres Absenken der Referenzfrequenz hat den Nachteil, dass der Flächenbedarf der Phasenregelschleife steigt, weil z. B. die Größe der Schwingkreisinduktivität im VCO umgekehrt proportional zu dessen Frequenz ist. Die angegebenen Werte stellen insofern einen Kompromiss dar. Die von der Phasenregelschleife eingestellte VCO-Frequenz von 750,88 MHz wird durch die nachgeschaltete Kette aus einem dritten (1:5)-Teiler div5h, einem Frequenzverdoppler mult2 und einem (1:13)-Teiler div13 auf die gewünschte GPS-Standardfrequenz von 23,104 MHz heruntergeteilt. Um die eingangs genannten Vorteile eines geringen Flächenbedarfs in Verbindung mit einem minimierten Stromverbrauch zu erzielen, werden die Blöcke mult1_2, div2, div19h, div5h, mult2 und div13 bevorzugt in bipolarer Technik und die Blöcke div5m, div51 und div191 in CMOS-Technik realisiert. Eine Schaltung der in der Fig. 7 gezeigten Art, also eine Kette mit Frequenzteilern, die, je nach Höhe der individuell zu teilenden Frequenz, in CMOS-Technik oder in Bipolartechnik realisiert sind, kann auch ohne die hier vorgestellte Startschaltung verwendet werden, um einen minimierten Strombedarf zu realisieren.

## Patentansprüche

1. Frequenzteilerschaltung (10) mit einer Kette von Flip-Flops, die durch eine Rückführung (12) zu einem rückgekoppelten Schieberegister verbunden sind, und mit einer Startschaltung (20), die beim Einschalten der Frequenzteilerschaltung (10) einen definierten Anfangszustand des Schieberegisters erzeugt, **dadurch gekennzeichnet, dass** die Startschaltung (20) die Rückführung (12) nach einem Einschalten der Frequenzteilerschaltung (10) für eine vorbestimmte Zeitdauer blockiert.

2. Frequenzteilerschaltung (10) nach Anspruch 1, **dadurch gekennzeichnet, dass** die vorbestimmte Zeitdauer größer oder gleich einer vorbestimmten Anzahl von Perioden eines Taktsignals ist, das jedem Flip-Flop des Schieberegisters synchron zugeführt wird.

3. Frequenzteilerschaltung (10) nach Anspruch 2, **dadurch gekennzeichnet, dass** die Startschaltung (20) ein Paar komplementärer MOS-Transistoren (40, 42) mit miteinander verbundenen Steueranschlüssen sowie ein RC-Glied (44) aufweist, Leitfähigkeitsstrecken der MOS-Transistoren (40, 42) über einen Ohm'schen Widerstand (R) des RC-Gliedes (44) verbunden sind und in Reihe zwischen einem Versorgungspotenzial (VCC) und einem Bezugspotenzial (gnd) liegen, und eine Kapazität (c) des RC-Gliedes (44) parallel zu einer Leitfähigkeitsstrecke eines der MOS-Transistoren (40, 42) liegt.

4. Frequenzteilerschaltung (10) nach wenigstens einem der vorhergehenden Ansprüche,
**dadurch gekennzeichnet, dass** die Flip-Flops emittergekoppelte Bipolartransistoren (Q24, Q25, ... , Q29) als Schaltelemente aufweisen.

5. Frequenzteilerschaltung (10) nach Anspruch 1, **dadurch gekennzeichnet, dass** die Rückführung (12) einen ersten Rückführzweig (14), einen zweiten Rückführzweig (16) sowie ein Und-Glied (18) aufweist, wobei das Und-Glied (18) den ersten Rückführzweig (14) und den zweiten Rückführzweig (16) mit einem Daten-Eingang eines ersten Flip-Flops des Schieberegisters verbindet und wobei der erste Rückführzweig (14) von einem vorletzten Flip-Flop und der zweite Rückführzweig (16) von einem letzten Flip-Flop des Schieberegisters gespeist wird.

6. Frequenzteilerschaltung (10) nach Anspruch 5, **dadurch gekennzeichnet, dass** Ausgänge des letzten und des vorletzten Latches des Schieberegisters durch ein Oder-Glied (38) verknüpft werden und dass ein Ausgang des Oder-Gliedes (38) einen Ausgang der Frequenzteilerschaltung (10) bildet.

7. Verwendung einer Frequenzteilerschaltung (10) nach wenigstens einem der vorhergehenden Ansprüche zur Teilung einer Taktsignalfrequenz, die größer als 200 MHz, insbesondere größer als 400 MHz ist.

8. Verwendung einer Frequenzteilerschaltung (10) nach wenigstens einem der vorhergehenden Ansprüche zur Erzeugung einer GPS-Standardfrequenz aus einer internen Referenzfrequenz eines Kommunikationsgerätes.

9. Verwendung nach Anspruch 8, **dadurch gekennzeichnet, dass** die GPS-Standardfrequenz durch eine Kette von Frequenz-Multiplizierern und Frequenzteilern und eine Phasenregelschleife erzeugt wird.

10. Verwendung nach Anspruch 9, **dadurch gekennzeichnet, dass** Frequenzteiler der Kette, die eine Frequenz teilen, die größer als eine Grenzfrequenz ist, in bipolarer Technik realisiert sind, während Frequenzteiler der Kette, die eine Frequenz teilen, die kleiner als die Grenzfrequenz ist, in CMOS-Technik realisiert sind.
